Europäisches Patentamt

European Patent Office

Office européen des brevets

(19)

(11) Veröffentlichungsnummer : **0 178 516**
**B1**

(12) **EUROPÄISCHE PATENTSCHRIFT**

(45) Veröffentlichungstag der Patentschrift :
09.08.89

(51) Int. Cl.⁴: **H 03 G   3/20, H 04 B   1/04**

(21) Anmeldenummer : 85112322.4

(22) Anmeldetag : 28.09.85

(54) **Hochfrequenz-Transistor-Leistungssender.**

(30) Priorität : 18.10.84 DE 3438222

(43) Veröffentlichungstag der Anmeldung :
23.04.86 Patentblatt 86/17

(45) Bekanntmachung des Hinweises auf die Patenterteilung : 09.08.89 Patentblatt 89/32

(84) Benannte Vertragsstaaten :
DE FR GB IT

(56) Entgegenhaltungen :
GB–A– 2 060 292
US–A– 4 442 407
RADIO COMMUNICATION, Januar 1984, Zeilen 43-44, London, GB; "Fail-safe "kiss" 5A psu with relay"

(73) Patentinhaber : **Rohde & Schwarz GmbH & Co. KG**
**Mühldorfstrasse 15**
**D-8000 München 80 (DE)**

(72) Erfinder : **Bauer, Helmut**
**Buchenweg 10**
**D-8134 Niederpöcking (DE)**

(74) Vertreter : **Graf, Walter, Dipl.-Ing.**
**Sckellstrasse 1**
**D-8000 München 80 (DE)**

## Beschreibung

Die Erfindung betrifft einen Hochfrequenz-Leistungssender laut Oberbegriff des Hauptanspruches.

Leistungssender dieser. Art sind bekannt (Neues von Rohde & Schwarz, 107, Herbst 84, Seiten 28, 29). Ändert sich im Betrieb die Eingangsimpedanz der angeschalteten Antenne und damit auch die einmal eingestellte Nennleistung des Senders, so kann dies durch entsprechende Änderung der Steuerleistung des Steuersenders ausgeregelt werden. Diese bekannte Regelungsart ist jedoch nur für relativ geringe Nennleistungsänderungen geeignet, da die Steuerleistung des Steuersenders nicht in beliebig grossen Grenzen geändert werden kann.

Bei den bisher üblichen Transistor-Leistungssendern beispielsweise für den UKW-Rundfunk werden ausschliesslich elektronisch geregelte Netzgeräte benutzt. Für eine bestimmte Nennleistung wird an dem geregelten Netzgerät eine entsprechende Speisegleichspannung eingestellt, die auch bei eventuellen Netzspannungsschwankungen automatisch konstant gehalten wird. Es ist auch bekannt, durch entsprechendes Verstellen des Reglers im Netzgerät kleinere Netzleistungsschwankungen auszuregeln. Solche geregelten Netzgeräte sind schaltungstechnisch sehr aufwendig und teuer, vor allem, wenn sie für Sender grosser Leistung von beispielsweise 10 KW ausgelegt werden müssen. Ein weiterer Nachteil solcher geregelter Netzgeräte ist ihre Störanfälligkeit.

Es ist Aufgabe der Erfindung, einen Hochfrequenz-Transistor-Leistungssender zu schaffen, der bezüglich seines Netzgerätes sehr einfach und billig aufgebaut ist und trotzdem in seinen Qualitätseigenschaften den bisher üblichen Sendern gleichwertig ist.

Diese Aufgabe wird ausgehend von einem Hochfrequenz-Leistungssender laut Oberbegriff des Hauptanspruches durch dessen kennzeichnende Merkmale gelöst. Vorteilhafte Weiterbildungen ergeben sich aus den Unteransprüchen.

Beim erfindungsgemässen Sender wird für die Regelung auf konstante Ausgangsnennleistung die Kombination einer Beeinflussung der Steuerleistung für geringfügige Nennleistungsänderungen und die Beeinflussung der Speisespannung durch entsprechende Änderung der Anzapfung eines einfachen Netztransformators für grössere Nennleistungsänderungen benutzt, was schaltungstechnisch sehr einfach und billig realisiert werden kann. Beim erfindungsgemässen Sender wird damit durch das funktionelle Zusammenwirken dieser kombinierten Steuerleistungs-Anzapfungs-Regelung mit wesentlich einfacheren Mitteln das gleiche erreicht wie mit einem bekannten teuren geregelten Netzgerät. Die erfindungsgemässe Lösung ist nicht nur wesentliche einfacher und billiger sondern auch wesentlich störunempfindlicher, da keine störempfindlichen Regelglieder für hohe Ströme und dergleichen nötig sind.

Trotzdem können sowohl Netzspannungsschwankungen als auch auf andere Einflüsse zurückzuführende Nennleistungsschwankungen in einem breiten Bereich schnell ausgeregelt werden.

Bei einer kombinierten Sende-Empfangs-Einrichtung ist es an sich bekannt, ein ungeregeltes Netzgerät bestehend aus einem Netztransformator, einem Gleichrichter und einem Siebglied zu verwenden und den Netztransformator sekundärseitig mit zwei Anzapfungen zu versehen, so dass über einen Relaisschalter bei grossem Stromverbrauch (Sendebetrieb) eine höhere Speisegleichspannung einstellbar ist als für den weniger Strom verbrauchenden Empfangsbetrieb (Radio Communication, Januar 84, Seiten 43, 44). Im Gleichstromspeisekreis ist hierzu ein den Speisegleichstrom messendes Relais angeordnet, das bei geringer Stromaufnahme die niedrigere Transformatoranzapfung und bei grösserer Stromaufnahme die höhere Transformatoranzapfung anschaltet. Für den erfindungsgemässen Zweck der Nennleistungsausregelung ist diese bekannte Schaltung wegen des quadratischen Zusammenhanges zwischen Speisegleichstrom und Leistungsänderung bei Impedanzschwankungen nicht geeignet.

Die Erfindung wird im folgenden anhand einer schematischen Zeichnung an einem Ausführungsbeispiel näher erläutert.

Die Fig. zeigt das Prinzipschaltbild eines UKW-Leistungssenders von beispielsweise 10 kW Ausgangsleistung bestehend aus einer Senderendstufe 1, die in bekannter Weise mit Leistungstransistoren aufgebaut ist, einem Steuersender 2, dessen Steuerleistung beispielsweise im Verhältnis 1 :2 über eine entsprechende Einstelleinrichtung 3 einstellbar ist (beispielsweise zwischen 10 und 20 W Steuerausgangsleistung), sowie einem einfachen ungeregelten Netzgerät 4 zur Erzeugung der Speisegleichspannung U für die Endstufe 1. Dieses Netzgerät 4 besteht aus einem einfachen Netztransformator 5, dessen primärwicklung 6 mit mehreren Anzapfungen 7 bis 10 versehen ist und dessen Sekundärwicklung 17 mit einem Gleichrichter 12 und einem nachgeschalteten Siebglied 13 verbunden ist. Den Anzapfungen 7 bis 10 ist ein schematisch angedeuteter Umschalter 14 zugeordnet, der über eine Steuerschaltung 15 umschaltbar ist. Der Umschalter 14 kann durch einzelne Relais oder ein entsprechendes Schrittschaltwerk gebildet sein. An dem zur Antenne 16 führenden Ausgang der Endstufe 1 ist ein Hochfrequenz-Leistungsmesser 17 angeschaltet, der mit der Steuerschaltung 15 verbunden ist. Die Steuerschaltung 15 steuert nicht nur den Umschalter 14, sondern auch die Stelleinrichtung 3 für die Änderung der Steuerleistung des Steuersenders 2.

Angenommen, die Nennleistung des Senders sei 10 kW, d. h. unabhängig von der Impedanz der jeweils angeschalteten Antenne 16 soll die Endstufe 1 jeweils eine Hochfrequenzleistung von 10 kW liefern. Nach den Pflichtenheften von UKW-Sendern müssen die Antennenimpedanzen innerhalb eines Stehwellenverhältnisses (VSWR) von 1,5 liegen, die Eingangsimpedanz der an den Sender anschließbaren Antennen kann also bei einer Nennimpedanz von 50 Ω zwischen 75 Ω und 33,5 Ω schwanken. Je nach angeschlossener Antenne benötigt zur Erzielung der gewünschten Ausgangsnennleistung die Endstufe eine entsprechend eingestellte Speisegleichspannung, für die kleinstmögliche Antennenimpedanz von 33,5 Ω ist beispielsweise eine Speisegleichspannung von 18 V nötig, für eine angepaßte Antenne von 50 Ω eine Speisespannung von 22,5 V und für eine relativ hochohmige Antenne mit 75 Ω Eingangsimpedanz eine Speisespannung von 28 V. Die Speisespannung U muß in diesem Beispiel also zwischen 18 und 28 V einstellbar sein und die Anzapfungen 7 bis 10 sind so gewählt, daß beispielsweise in Schritten von 5 % Primärspannungsänderung die sekundärseitig erzeugte Speisespannung U schrittweise in diesen Grenzen geändert werden kann.

Bei der Inbetriebnahme des Senders wird zunächst von Hand durch entsprechende Änderung des Umschalters 14 die Speisespannung U solange geändert, bis für die angeschaltete Antenne 16 sich die gewünschte Ausgangsnennleistung von 10 kW ergibt. Der Sender ist damit eingestellt. In der Praxis sind die Antenneneingangsimpedanzen im wesentlichen konstan und weitgehendst unabhängig von Witterungs- und Alterungseinflüssen. Allerdings kann sich die Nennleistung beispielsweise durch Änderung der Netzspannung ändern. Wird über den Leistungsmesser 17 eine entsprechende Änderung der Nennleistung festgestellt, so wird über die Steuerschaltung 15 die Steuerleistung des Steuersenders 2 entsprechend geändert. Die Änderungsmöglichkeit der Steuerleistung ist begrenzt. Sinkt beispielsweise die Netzspannung ab und damit auch die Ausgangsleistung, so wird zunächst über die Steuerleistung versucht, diese Leistungsabnahme auszuregeln. Erreicht die Stelleinrichtung 3 für die Steuerleistung ihren oberen Anschlag, d. h. ist zur Ausregelung der Netzspannungsabsenkung die Steuerleistung nicht höher einstellbar, wird dies durch die schematisch angedeutete Wirkverbindung 18 der Steuerschaltung 15 mitgeteilt und diese schaltet daraufhin automatisch die nächste Anzapfung für eine Erhöhung der Speisespannung U an, bis schließlich die gewünschte Nennleistung wieder erreicht ist. Diese wird zunächst etwas zu hoch sein, was dann durch Zurückregeln der Steuerleistung wieder ausgeglichen wird. Die Entscheidung in der Steuerschaltung 15 darüber, ob nun über die Steuerleistung des Steuersenders 2 oder über die Umschaltung der Anzapfungen 7 bis 10 die Ausgangsleistung ausgeregelt werden soll, kann auch in ·Abhängigkeit von anderen Kriterien getroffen werden, beispielsweise in Abhängigkeit vor. der Größe der über den Leistungsmesser 17 festgestellten Nennleistungsänderung am Ausgang der Endstufe 1. Außerdem kann durch entsprechende zusätzliche Dedektoren der Wirkungsgrad des Senders bei dieser Entscheidung mitberücksichtigt werden, indem beispielsweise die von den Transistoren der Endstufe aufgenommene Leistung in Bezug auf die Nennleistung gesetzt wird und in Abhängigkeit davon dann bereits eine Umschaltung der Anzapfungen durchgeführt wird anstelle einer entsprechenden Leistungsregelung über die Steuerleistung des Steuersenders.

In den gezeigten Ausführungsbeispiel ist nur ein einfacher 1-Phasen-Netztransformator dargestellt, aus Leistungsgründen ist es zweckmäßig, hierfür einen 3-Phasen-Netztransformator zu benutzen, der dann natürlich an allen drei Primärwicklungen entsprechende Anzapfungen aufweist.

Die Umschaltung der Schaltvorrichtung 14 könnte im einfachsten Fall auch durch einen Spannungsdetektor erfolgen, mit dem Netzspannungsschwankungen feststellbar sind. Dieser Netzspannungs-Detektor könnte beispielsweise so dimensioniert sein, dass bei einer Änderung der Netzspannung um plus oder minus 5 % automatisch die Schaltvorrichtung 14 auf die nächst höhere bzw. nächst niedrigere Transformatoranzapfung umschaltet. Die Transformatoranzapfungen sind in diesem Fall dann natürlich so abgestuft, dass sie jeweils einer 5 %igen Spannungsänderung entsprechen. Dieser Spannungsdetektor arbeitet in diesem einfachsten Lösungsbeispiel unabhängig von der Steuerleistungs-Regelung über den Leistungsmesser 17. Es ist daher nötig, dass der Regelbereich des Steuersenders mindestens so gross ist, dass mit Sicherheit die primärseitigen 5 %igen Netzspannungsänderungen ausgeregelt werden, d. h. in diesem Fall übernimmt automatisch der Steuersender die Ausregelung von 10 % Nennleistungsänderung (wegen des quadratischen Zusammenhangs zwischen Spannungsänderung und Leistungsänderung) und bei Netzspannungsänderungen mehr als 5 % wird über den Spannungsdetektor automatisch die Anzapfung des Transformators geändert, die hierdurch bedingte Änderung der Nennleistung wird dann anschliessend automatisch wieder über die Steuerleistung ausgeregelt. Ein Spannungsdetektor mit zugehörigen Schwellwerten kann einfacher und billiger realisiert werden als ein entsprechender Steuerkreis für die Anzapfungs-Steuerung in Abhängigkeit von der Nennleistung.

Die Umschaltung der Transformatoranzapfungen kann im einfachsten Fall über einen Relaisschalter (Schütz) erfolgen, wenn beispielsweise nur plus oder minus 5 % Netzspannungsänderungen ausgeregelt werden sollen. In diesem Fall erfolgt die anfängliche Einstellung der gewünschten Nennleistung von Hand dadurch, dass an einer Klemmleiste, an welcher die Transformatoranzapfungen enden, die richtige Ausgangsspannung U eingestellt wird. Der Relaisschalter wird an die beiden unmittelbar benachbarten Anzapfungen dieser so gefundenen Grundeinstellung angeschaltet. Wenn die Netzspannung beispielsweise um 5 % absinkt, wird über den Relaisschalter automatisch auf die nächst höhere Anzapfung umgeschaltet, bei 5 %iger Netzspannungserhöhung entsprechend auf die nächst niedrigere Anzapfung. Auch dies ist eine besonders einfache und billige Lösung und genügt für die meisten Anwendungsfälle.

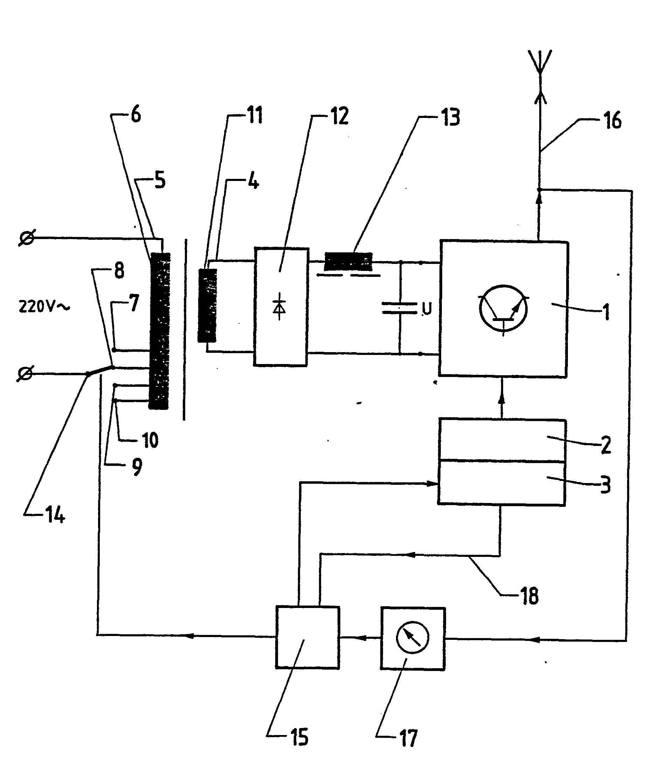

**Patentansprüche**

1. Hochfrequenz-Leistungssender, dessen über ein Netzgerät gleichstromgespeiste und über einen Steuersender (2, 3) angesteuerte Endstufe (1) mit Leistungstransistoren aufgebaut ist, mit einem ausgangsseitig angeschalteten Leistungsmesser (17), der mit einer Steuerschaltung (15) verbunden ist, durch welche geringe Änderungen der Nennleistung durch entsprechende Änderung der Steuerleistung des Steuersenders (2, 3) ausregelbar sind, gekennzeichnet durch die Kombination folgender Merkmale :

a) das Netzgerät ist in an sich bekannter Weise ungeregelt und besteht nur aus einem Netztransformator (5), einem Gleichrichter (12) und einem Siebglied (13)

b) der Netztransformator (5) dieses Netzgerätes besitzt mehrere Anzapfungen (7 bis 10), mit denen über eine Schaltvorrichtung (14) die Speisegleichspannung (U) schrittweise einstellbar ist

c) die mit dem Leistungsmesser (17) verbundene Steuerschaltung (15) ist mit dieser Schaltvorrichtung (14) der Transformatoranzapfungen (7 bis 10) verbunden, so dass grössere Änderungen der Nennleistung durch entsprechende Änderung der Transformatoranzapfungen (7 bis 10) ausregelbar sind.

2. Sender nach Anspruch 1, dadurch gekennzeichnet, daß die Anzapfungen (7 bis 10) an der Primärseite des Netztransformators (5) vorgesehen sind.

3. Sender nach Anspruch 1 oder 2, dadurch gekennzeichnet, daß der Netztransformator (5) als 3-Phasen-Transformator ausgebildet ist.

**Claims**

1. High-frequency power transmitter, the output stage (1) of which, supplied with direct current via a power supply unit and driven via a control transmitter (2, 3), incorporates power transistors, having a wattmeter (17) interfaced on the output side and connected to a control circuit (15) by which minor variations in the rated power can be corrected by correspondingly varying the control power from the control transmitter (2, 3), characterised by the combination of the following features :

a) the power supply unit is unregulated in a manner known per se and consists only of a power transformer (5), a rectifier (12) and a filter element (13) ;

b) the power transformer (5) of said power supply unit has a plurality of taps (7 to 10), by means of which the supply-system direct voltage (U) can be adjusted stepwise via an operating device (14) ;

c) the control circuit (15) connected to the wattmeter (17) is connected to said operating device (14) for the transformer taps (7 to 10), thereby allowing major variations in the rated power to be corrected by correspondingly varying the transformer taps (7 to 10).

2. Transmitter according to claim 1, characterised in that the taps (7 to 10) are provided on the primary side of the power transformer (5).

3. Transmitter according to claim 1 or 2, characterised in that the power transformer (5) is a three-phase transformer.

**Revendications**

1. Emetteur de puissance haute fréquence, dont l'étage terminal (1), alimenté en courant continu par l'intermédiaire d'une unité d'alimentation et commandé par l'intermédiaire d'un émetteur de commande (2, 3), est constitué par des transistors de puissance, avec un dispositif de mesure de la puissance (17) branché côté sortie, qui est relié à un circuit de commande (15), grâce auquel de faibles modifications de la puissance nominale sont susceptibles d'être réglées par une modification correspondante de la puissance de commande de l'émetteur de commande (2, 3), émetteur caractérisé par la combinaison des particularités suivantes :

a) l'unité d'alimentation est, de façon connue en soi, non réglée et est uniquement constituée par un transformateur d'alimentation (5), un redresseur (12) et un élément de filtrage (13),

b) le transformateur d'alimentation (5) de cette unité d'alimentation comporte plusieurs prises de réglage (7 à 10) grâce auxquelles, par l'intermédiaire d'un dispositif de commutation (14), la tension d'alimentation (U) est susceptible d'être réglée progressivement,

c) le circuit de commande (15) relié au dispositif de réglage de la puissance (17) est relié à ce dispositif de commutation (14) des prises de réglage (7 à 10) du transformateur d'alimentation, de sorte que des modifications plus importantes de la puissance nominale sont réglées par un changement correspondant des prises (7 à 10) du transformateur d'alimentation.

2. Emetteur selon la revendication 1, caractérisé en ce que les prises de réglage (7 à 10) sont prévues sur le côté primaire du transformateur d'alimentation (5).

3. Emetteur selon la revendication 1 ou 2, caractérisé en ce que le transformateur d'alimentation (5) est un transformateur triphasé.